(19) Europäisches Patentamt
European Patent Office
Office européen des brevets

(11) **EP 3 996 027 A1**

(12) **EUROPEAN PATENT APPLICATION**

(43) Date of publication:
**11.05.2022 Bulletin 2022/19**

(51) International Patent Classification (IPC):
***G06Q 40/04*** *(2012.01)*

(21) Application number: **20206280.8**

(52) Cooperative Patent Classification (CPC):
**G06Q 10/063; G06Q 10/20; G06Q 50/06**

(22) Date of filing: **06.11.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **ABB Schweiz AG**
**5400 Baden (CH)**
• **Hitachi Energy Switzerland AG**
**5400 Baden (CH)**

(72) Inventors:
• **PJETRI, Erald**
**31-036 Kraków (PL)**
• **OTTEWILL, James**
**31-143 Kraków (PL)**
• **FIRLA, Marcin**
**31-553 Kraków (PL)**

(74) Representative: **Vossius & Partner**
**Patentanwälte Rechtsanwälte mbB**
**Siebertstrasse 3**
**81675 München (DE)**

(54) **METHOD AND SYSTEM FOR MONITORING AND/OR OPERATING A POWER SYSTEM ASSET**

(57) Techniques for monitoring and/or operating a power system asset are provided. A series of sets of first model parameter values (71-73) of a power system asset model is determined from data obtained by measurements. The series of sets of first model parameter values (71-73) is used to determine a set of second model parameter values (79) of a parameter evolution model different from the power system asset model. The parameter evolution model describes an evolution of one, several or all first model parameter values (71-73) of the power system asset model. An output is generated in dependence on at least one of the sets of first model parameter values (71-73) of the power system asset model and the set of second model parameter values (79) of the parameter evolution model.

FIG. 5

Processed by Luminess, 75001 PARIS (FR)

**Description**

FIELD OF THE INVENTION

The invention relates to methods and systems for monitoring and/or operating a power system asset. The invention relates to methods and systems for monitoring and/or operating a power system asset that use a model of the power system asset.

BACKGROUND OF THE INVENTION

Power generation, transmission, and distribution systems include a number of power system assets, such as rechargeable energy storage systems, transformers, generators (such as distributed energy resources (DERs)). It is important to monitor the condition of such power system assets, in order to ensure reliable and stable system operation, trigger maintenance or human inspection tasks, and/or determine operating points for power system assets.

Techniques for monitoring and/or operating power system assets may be model-based. For illustration, a model of a power system asset may have a parameterization and parameter values for the various parameters may be determined based on measurements captured during field operation.

WO 2015/160745 A2 discloses a method for predicting a performance of an electrical energy storage system which includes receiving, as input, time series of data points pertaining to a plurality of operational parameters of the electrical energy storage system. The input time series is provided to a model that simulates the dynamics of the electrical energy storage system. A plurality of performance indicators of the electrical energy storage system may be calculated based on the simulated dynamics of the electrical energy storage system.

US 2007/0194756 A1 discloses a method of monitoring a battery which includes measuring an open circuit voltage on the battery to determine a measured state of charge after at least one use, obtaining a calculated state of charge based on a state of charge prior to the at least one use and a discharge of the battery during the at least one use, and determining a state of the battery based at least in part on a difference between the calculated state of charge and the measured state of charge.

EP 2 337 184 A2 discloses a grid-connected energy storage system capable of increasing the efficiency of a converter and a method of controlling the system.

Conventional model-based approaches for monitoring a power system asset have various shortcomings. For illustration, the state of the power system asset may no longer be appropriately reflected by the power system asset model when the state of the power system asset degrades significantly in the time interval that has lapsed after the parameter values for the power system asset model are determined. Re-determining the parameter values in a recurrent manner may mitigate this issue, but does not allow long-term trends in power system asset state evolution to be systematically captured. Trending is challenging when using conventional model-based approaches for monitoring a power system asset, in particular when considering that there is a vast number of possible operating conditions. Conventional model-based approaches frequently require significant involvement of a human engineer, e.g., for a configuration processes, which makes these approaches error-prone.

SUMMARY

There is a need in the art for improved methods and systems that mitigate at least some of the shortcomings of conventional model-based techniques for monitoring and/or operating a power system asset. There is in particular a need in the art for methods and systems that allow trends to be identified in a systematic manner, that facilitate trending, and/or that reduce human expert involvement.

According to embodiments of the invention, parameter values of a power system asset model are determined. This is done in a recurrent manner, e.g., periodically. A parameter evolution model that determines the evolution of one, several or all of the parameter values of the power system asset model is established. This may comprise determining a set of second model parameter values for parameters of the parameter evolution model that defines how the one, several or all of the parameter values of the power system asset model.

The parameter evolution model is distinct from the power system asset model. Using the parameter evolution model, trends in the time-evolution of the parameter values of the power system asset model may be systematically captured and quantified.

The determination of the parameter values of a power system asset model may be performed using a data-driven approach, e.g., based on measurements. The measurements may be captured by one or several sensors, including sensors mounted in or on the power system asset.

The set of second model parameter values for the parameter evolution model that defines how one, several or all of the parameter values of the power system asset model evolve is directly or indirectly dependent on the captured measurements. For illustration, the parameter evolution model may be trained using sets of first model parameter values as inputs, wherein each of the sets is determined for the power system asset model using measurements and each of the sets is associated with a different time or time interval.

The method and system according to embodiments thus provide a hybrid data-driven and model-based power system asset monitoring system, which provide an end user with insights into an actual current state of the power system asset and is capable of predicting its future states.

Different operating scenarios (e.g., different hypothetical future control actions) may be accommodated in trending. For illustration, the parameter evolution model may be used to predict the future evolution of the power system asset model for one or several operating scenarios.

Control signals and/or control parameters may be automatically set in control units in order to track the operating scenario. This can include temperature control, protection system (e.g., circuit breaker states), charge/discharge rate etc.

A method of monitoring and/or operating a power system asset according to an embodiment comprises receiving, from at least one data acquisition unit, measurements indicative of a state of the power system asset. The method comprises processing the received measurements to determine a series of sets of first model parameter values of a power system asset model, each of the sets of first model parameter values being determined for a different time or time interval. The method comprises determining, using the series of sets of first model parameter values, a set of second model parameter values of a parameter evolution model different from the power system asset model, the parameter evolution model describing an evolution of one, several or all first model parameter values of the power system asset model. The method comprises generating and providing an output in dependence on at least one of the sets of first model parameter values of the power system asset model and the set of second model parameter values of the parameter evolution model.

The parameter evolution model may describe the evolution of one, several or all first model parameter values of the power system asset model as a function of operating conditions and/or ambient conditions.

Generating the output may comprise performing degradation diagnostics using the parameter evolution model. The output may be generated as a function of a result of the degradation diagnostics.

The method may further comprise using the parameter evolution model to generate a forecast for a future evolution of the one, several or all first model parameter values of the power system asset model.

The forecast may be used to generate an output that may comprise at least one of the following: a remaining useful life (RUL) determined based on the forecast future evolution, a future power system asset state, a future performance of the power system asset.

The parameter evolution model may describe the evolution of one, several or all first model parameter values of the power system asset model as a function of ambient conditions and/or operating conditions.

The method may comprise intermittently adjusting ambient and/or operating conditions for the power system asset to determine the set of second model parameter values for the adjusted ambient and/or operating conditions.

Intermittently adjusting the ambient and/or operating conditions may comprise adjusting the ambient and/or operating conditions in response to a user input.

Intermittently adjusting the ambient and/or operating conditions may comprise issuing commands to control units to adjust the ambient and/or operating conditions and, after at least two or at least three sets of first model parameter values have been determined for the adjusted ambient and/or operating conditions, issuing command to the control units to return the ambient and/or operating conditions to their previous values.

Intermittently adjusting the ambient and/or operating conditions may comprise one or several of: performing temperature control, controlling at least one protection system (e.g., circuit breaker state), controlling at least one switch state, controlling a charge rate, controlling a discharge rate, without being limited thereto.

A set of second model parameter values may respectively be determined for a parameterization of the parameter evolution model (which may take the form of coefficients of a linear or non-linear regression model or of a machine learning model) for each one of a plurality of ambient and/or operating conditions. This may respectively involve intermittently adjusting the ambient and/or operating conditions to certain values, to determine the set of second model parameter values associated with that ambient and/or operating conditions. The adjustment and determination of the set of second model parameter values may be repeated, until the parameter values for the parameterization of the parameter evolution model have been determined for several different ambient and/or operating conditions.

The method may comprise using the parameter evolution model to generate several forecasts for a future evolution of the one, several or all first model parameter values of the power system asset model, the several forecasts being determined for different future ambient conditions and/or operating conditions.

The method may further comprise receiving user input specifying at least a sub-set of the future ambient conditions and/or operating conditions, and/or automatically generating at least a sub-set of the future ambient conditions and/or operating conditions.

The method may further comprise using the power system asset model to perform diagnostics for events that happen on a first time scale.

The method may further comprise using the parameter evolution model to identify trends that happen on a second time scale, the second time scale exceeding the first time scale.

The first time scale may be equal to, less than, or similar to a sampling interval at which measurements are received or a time interval for which a set of first model parameter values is respectively determined.

At least one of the sets of first model parameter values of the power system asset model may be used in combination with measurements to compute a current power system asset state, to compute residuals between measurements and observables estimated from the current power system asset state, and to perform diagnostics for events that happen on the first time scale based on the residuals.

The output may comprise one or several of: information output via a human machine interface (HMI) and/or control signals that are output to a controller.

The output may comprise power system asset health information.

The output may comprise an alarm or warning.

The control signals may be output to a microgrid controller.

The sets of first model parameter values and the set of second model parameter values of a parameter evolution model may be determined separately for each of the plurality of cells or cell strings.

Determining a set of first model parameter values may comprise solving a discrete-time linear differential equation.

Determining the set of second model parameter values may comprise at least one of machine learning, fitting, or regression analysis, in particular linear regression.

A computing system comprises an interface operative to receive measurements indicative of a state of an energy storage system and at least one integrated circuit coupled to the interface. The at least one integrated circuit is operative to process the received measurements to determine a series of sets of first model parameter values for a power system asset model, each of the sets of first model parameter values being determined for a different time or time interval, determine, using the series of sets of first model parameter values, a set of second model parameter values of a parameter evolution model different from the power system asset model, the parameter evolution model describing an evolution of one, several or all first model parameter values of the power system asset model, and generate and provide an output in dependence on at least one of the sets of first model parameter values of the power system asset model and the set of second model parameter values of the parameter evolution model.

The computing system may be operative to perform the method according to an embodiment.

A system comprises a power system asset, a data acquisition unit operative to collect measurements indicative of a state of the power system asset, and the computing system according to an embodiment coupled to the data acquisition unit.

The power system asset may be a transformer, a distributed energy resource (DER), a rechargeable energy storage system, without being limited thereto. By determining the set of second model parameter values for the parameter evolution model, long-term trends of power system asset state evolution may be systematically determined. The sets of first model parameter values may be stored and evaluated in order to observe a longer-term degradations in the system, as reflected by the parameter evolution model.

A method of monitoring and/or operating a rechargeable energy storage system (ESS) according to an embodiment comprises receiving, from at least one data acquisition unit, measurements indicative of a state of the ESS. The method comprises processing the received measurements to determine a series of sets of first model parameter values of an ESS model, each of the sets of first model parameter values being determined for a different time or time interval. The method comprises determining, using the series of sets of first model parameter values, a set of second model parameter values of a parameter evolution model different from the ESS model, the parameter evolution model describing an evolution of one, several or all first model parameter values of the ESS model. The method comprises generating and providing an output in dependence on at least one of the sets of first model parameter values of the ESS model and the set of second model parameter values of the parameter evolution model.

The parameter evolution model may describe the evolution of one, several or all first model parameter values of the ESS model as a function of operating conditions and/or ambient conditions.

Generating the output may comprise performing degradation diagnostics using the parameter evolution model. The output may be generated as a function of a result of the degradation diagnostics.

The method may further comprise using the parameter evolution model to generate a forecast for a future evolution of the one, several or all first model parameter values of the ESS model.

The forecast may be used to generate an output that may comprise at least one of the following: a remaining useful life (RUL) determined based on the forecast future evolution, a future ESS state, a future performance of the ESS.

The parameter evolution model may describe the evolution of one, several or all first model parameter values of the ESS model as a function of ambient conditions and/or operating conditions.

The method may comprise intermittently adjusting ambient and/or operating conditions for the ESS to determine the set of second model parameter values for the adjusted ambient and/or operating conditions.

Intermittently adjusting the ambient and/or operating conditions may comprise adjusting the ambient and/or operating conditions in response to a user input.

Intermittently adjusting the ambient and/or operating conditions may comprise issuing commands to control units to adjust the ambient and/or operating conditions and, after at least two or at least three sets of first model parameter values have been determined for the adjusted ambient and/or operating conditions, issuing a command to the control units to return the ambient and/or operating conditions to their previous values.

Intermittently adjusting the ambient and/or operating conditions may comprise one or several of: performing temperature control (e.g., including controlling a temperature of an enclosure in which the ESS is mounted), controlling at least one protection system (e.g., circuit breaker state), controlling at least one switch state, controlling a charge rate, controlling a discharge rate, without being limited thereto.

A set of second model parameter values may respectively be determined for a parameterization of the parameter evolution model (which may take the form of coefficients of a linear or non-linear regression model or of a machine learning model) for each one of a plurality of ambient and/or operating conditions. This may respectively involve intermittently adjusting the ambient and/or operating conditions to certain values, to determine the set of second model parameter values associated with that ambient and/or operating conditions. The adjustment and determination of the set of second model parameter values may be repeated, until the parameter values for the parameterization of the parameter evolution model have been determined for several different ambient and/or operating conditions.

The method may comprise using the parameter evolution model to generate several forecasts for a future evolution of the one, several or all first model parameter values of the ESS model, the several forecasts being determined for different future ambient conditions and/or operating conditions.

The method may further comprise receiving user input specifying at least a sub-set of the future ambient conditions and/or operating conditions, and/or automatically generating at least a sub-set of the future ambient conditions and/or operating conditions.

The method may further comprise using the ESS model to perform diagnostics for events that happen on a first time scale.

The method may further comprise using the parameter evolution model to identify trends that happen on a second time scale, the second time scale exceeding the first time scale.

The first time scale may be equal to, less than, or similar to a sampling interval at which measurements are received or a time interval for which a set of first model parameter values is respectively determined.

At least one of the sets of first model parameter values of the ESS model may be used in combination with measurements to compute a current ESS state, to compute residuals between measurements and observables estimated from the current ESS state, and to perform diagnostics for events that happen on the first time scale based on the residuals.

The output may comprise one or several of: information output via a human machine interface (HMI) and/or control signals that are output to a controller.

The output may comprise ESS health information.

The output may comprise an alarm or warning.

The control signals may be output to a battery management system (BMS) or microgrid controller.

The control signals may control at least one of charge rate, discharge rate, ESS ambient temperature, depth of discharge, a protection system.

The ESS may be an electro-chemical ESS, in particular a rechargeable battery energy storage system (BESS).

The BESS may comprise a plurality of cells or a plurality of cell strings.

The cells may be lithium-ion cells.

The sets of first model parameter values and the set of second model parameter values of a parameter evolution model may be determined separately for each of the plurality of cells or cell strings.

Determining a set of first model parameter values may comprise solving a discrete-time linear differential equation.

Determining the set of second model parameter values may comprise at least one of machine learning, fitting, or regression analysis, in particular linear regression.

The set of first model parameter values may comprise resistances and/or capacitances and/or inductances.

The set of first model parameter values may comprise a parameter value for a self-discharging resistance.

The set of first model parameter values may comprise parameter values for a first RC element to model hysteresis for charging and discharging.

The set of first model parameter values may comprise parameter values for a second RC element to model long-time transients.

The set of first model parameter values may comprise parameter values for a third RC element to model short-time transients.

A computing system comprises an interface operative to receive measurements indicative of a state of an energy storage system (ESS) and at least one integrated circuit coupled to the interface. The at least one integrated circuit is operative to process the received measurements to determine a series of sets of first model parameter values for an ESS model, each of the sets of first model parameter values being determined for a different time or time interval. The at least one integrated circuit is operative to determine, using the series of sets of first model parameter values, a set of second model parameter values of a parameter evolution model different from the ESS model. The parameter evolution model describes an evolution of one, several or all first model parameter values of the ESS model. The at least one integrated circuit is operative to generate and provide an output in dependence on at least one of the sets of first model parameter values of the ESS model and the set of second model parameter values of the parameter evolution model.

The parameter evolution model may describe the evolution of one, several or all first model parameter values of the ESS model as a function of operating conditions and/or ambient conditions.

The computing system may be operative such that generating the output may comprise performing degradation diagnostics using the parameter evolution model. The computing system may be operative such that the output may be generated as a function of a result of the degradation diagnostics.

The computing system may be operative to use the parameter evolution model to generate a forecast for a future evolution of the one, several or all first model parameter values of the ESS model.

The computing system may be operative to use the forecast to generate an output that may comprise at least one of the following: a remaining useful life (RUL) determined based on the forecast future evolution, a future ESS state, a future performance of the ESS.

The parameter evolution model may describe the evolution of one, several or all first model parameter values of the ESS model as a function of ambient conditions and/or operating conditions.

The computing system may be operative to intermittently adjust ambient and/or operating conditions for the ESS to determine the set of second model parameter values for the adjusted ambient and/or operating conditions.

The computing system may be operative such that intermittently adjusting the ambient and/or operating conditions may comprise adjusting the ambient and/or operating conditions in response to a user input.

The computing system may be operative such that intermittently adjusting the ambient and/or operating conditions may comprise issuing commands to control units to adjust the ambient and/or operating conditions and, after at least two or at least three sets of first model parameter values have been determined for the adjusted ambient and/or operating conditions, issuing a command to the control units to return the ambient and/or operating conditions to their previous values.

The computing system may be operative such that intermittently adjusting the ambient and/or operating conditions may comprise one or several of: performing temperature control (e.g., including controlling a temperature of an enclosure in which the ESS is mounted), controlling at least one protection system (e.g., circuit breaker state), controlling at least one switch state, controlling a charge rate, controlling a discharge rate, without being limited thereto.

The computing system may be operative to respectively determine a set of second model parameter values for a parameterization of the parameter evolution model (which may take the form of coefficients of a linear or non-linear regression model or of a machine learning model) for each one of a plurality of ambient and/or operating conditions. This may respectively involve intermittently adjusting the ambient and/or operating conditions to certain values, to determine the set of second model parameter values associated with that ambient and/or operating conditions. The adjustment and determination of the set of second model parameter values may be repeated, until the parameter values for the parameterization of the parameter evolution model have been determined for several different ambient and/or operating conditions.

The computing system may be operative to use the parameter evolution model to generate several forecasts for a future evolution of the one, several or all first model parameter values of the ESS model, the several forecasts being determined for different future ambient conditions and/or operating conditions.

The computing system may be operative to receive user input specifying at least a sub-set of the future ambient conditions and/or operating conditions, and/or to automatically generate at least a sub-set of the future ambient conditions and/or operating conditions.

The computing system may be operative to use the ESS model to perform diagnostics for events that happen on a first time scale.

The computing system may be operative to use the parameter evolution model to identify trends that happen on a second time scale, the second time scale exceeding the first time scale.

The first time scale may be equal to, less than, or similar to a sampling interval at which measurements are received or a time interval for which a set of first model parameter values is respectively determined.

The computing system may be operative to use at least one of the sets of first model parameter values of the ESS model in combination with measurements to compute a current ESS state, to compute residuals between measurements and observables estimated from the current ESS state, and to perform diagnostics for events that happen on the first time scale based on the residuals.

The computing system may be operative such that the output comprises one or several of: information output via a human machine interface (HMI) and/or control signals that are output to a controller.

The computing system may be operative such that the output comprises ESS health information.

The computing system may be operative such that the output comprises an alarm or warning.

The computing system may be operative such that the control signals are output to a battery management system (BMS) or microgrid controller.

The computing system may be operative such that the control signals control at least one of charge rate, discharge rate, ESS ambient temperature, depth of discharge, a protection system.

The ESS may be an electro-chemical ESS, in particular a rechargeable battery energy storage system (BESS).

The BESS may comprise a plurality of cells or a plurality of cell strings.

The cells may be lithium-ion cells.

The computing system may be operative such that the sets of first model parameter values and the set of second model parameter values of a parameter evolution model may be determined separately for each of the plurality of cells or cell strings.

The computing system may be operative such that determining a set of first model parameter values comprises solving a discrete-time linear differential equation.

The computing system may be operative such that determining the set of second model parameter values may comprise at least one of machine learning, fitting, or regression analysis, in particular linear regression.

The computing system may be operative to determine the set of first model parameter values comprising resistances and/or capacitances and/or inductances.

The computing system may be operative to determine the set of first model parameter values comprising a parameter value for a self-discharging resistance.

The computing system may be operative to determine the set of first model parameter values comprising parameter values for a first RC element to model hysteresis for charging and discharging.

The computing system may be operative to determine the set of first model parameter values comprising parameter values for a second RC element to model long-time transients.

The computing system may be operative to determine the set of first model parameter values comprising parameter values for a third RC element to model short-time transients.

A system comprises a battery energy storage system (BESS), a data acquisition unit operative to collect measurements indicative of a state of the BESS, and the computing system according to an embodiment coupled to the data acquisition unit.

The system may comprise an enclosure in which the BESS is mounted.

The computing system may be mounted in the enclosure.

The system may comprise a battery management system mounted in the enclosure.

When data-driven models are implemented that describe the evolution of parameter value(s) of a power system asset model with respect to operating and/or ambient conditions, it is possible to assess the impact on both performance and remaining useful lifetime of various operating scenarios and/or ambient conditions.

By combining a power system asset model for a power system with the parameter evolution model, diagnostics, prognostics and optimization may be performed. Thus, the systems and methods can be quickly and easily deployed with greater accuracy, with limited risk of human error due to incorrect setting of parameters and with reduced system maintenance.

The methods and systems can be used in association with rechargeable energy storage systems (in particular a BESS), a transformer, an energy generation system, or other power system assets of power generation, transmission and/or distribution systems, without being limited thereto.

BRIEF DESCRIPTION OF THE DRAWINGS

The subject-matter of the invention will be explained in more detail with reference to preferred exemplary embodiments which are illustrated in the attached drawings, in which:

Figure 1 is a schematic representation of a system according to an embodiment.
Figure 2 is a schematic representation of a computing system according to an embodiment.
Figure 3 is a schematic representation of a system according to an embodiment.
Figure 4 is a flow chart of a method according to an embodiment.
Figure 5 is a graph for explaining operation of methods and computing systems according to embodiments.
Figure 6 is a flow chart of a method according to an embodiment.
Figure 7 is a circuit diagram of a battery energy storage system (BESS) model.
Figure 8 is a flow chart of a method according to an embodiment.
Figure 9 is a flow chart of a method according to an embodiment.

Figure 10 is a graph illustrating the identification of events on a first time scale based on measurements and a power system asset model.

Figure 11 is a flow chart of a method according to an embodiment.

Figure 12 is a flow chart of a method according to an embodiment.

Figure 13 is a flow chart of a method according to an embodiment.

Figure 14 is a flow chart of a method according to an embodiment.

Figure 15 is a schematic representation of a system according to an embodiment.

Figure 16 is a schematic representation of a system according to an embodiment.

## DETAILED DESCRIPTION OF EMBODIMENTS

Exemplary embodiments of the invention will be described with reference to the drawings in which identical or similar reference signs designate identical or similar elements. While some embodiments will be described in the context of a battery energy storage system (BESS), the invention is not limited thereto. While embodiments of the invention are applicable to energy storage systems that each are based on lithium-ion batteries, the invention is not limited thereto any may be applied to other types of BESS or other power system assets of power generation, transmission and/or distribution systems.

The features of embodiments may be combined with each other, unless specifically noted otherwise.

Identical or similar reference numerals are used to designate identical or similar elements in the drawings.

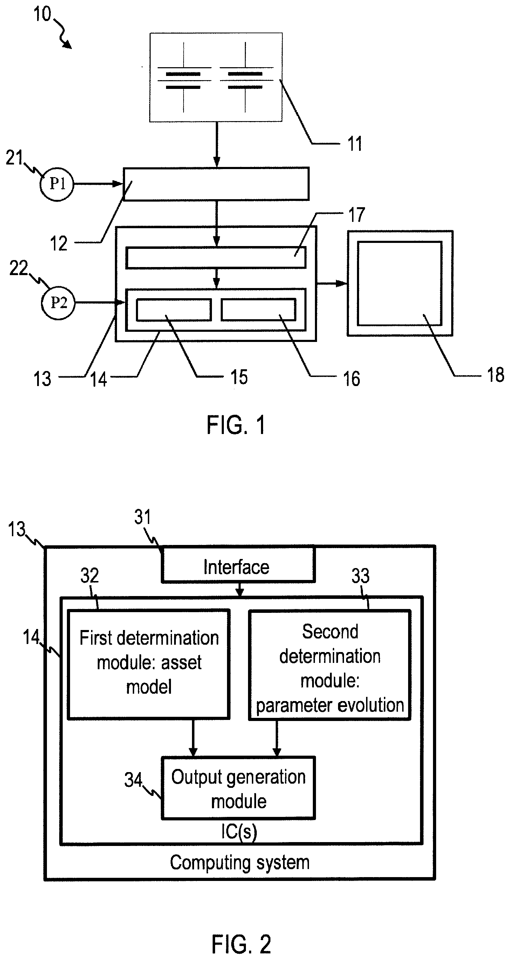

Figure 1 is a schematic representation of a system 10. The system 10 comprises a rechargeable battery energy storage system (BESS) 11. The rechargeable BESS may comprise a plurality of parallel cell strings. Each of the plurality of parallel cell strings may comprise a plurality of cells. The plurality of parallel cell may be coupled to a point of common coupling via converters and/or transformers. The cell strings may each include at least one series connection of cells, e.g., lithium-ion cells. Some or all of the strings may include several series connections of cells, which are coupled in parallel to each other.

The BESS 11 may be coupled to a grid at the point of common coupling. The grid may be a national or regional power grid. The grid may be an islanded grid, such as a microgrid.

As used herein, the term "battery" encompasses rechargeable batteries.

The BESS 11 may be operative to provide ancillary services to the grid, such as providing frequency stabilization, load regulation, and/or voltage support. A BESS 11 operative to provide such ancillary services is often dimensioned to accommodate peak needs, but operates at much lower powers or loads that those for which it is designed throughout most of its operation. The techniques described in detail herein are particularly suitable for such BESSs that must be able to provide certain performance characteristics, e.g., due to contractual obligations or to accommodate worst case scenarios, but that typically are operated at loads that are much smaller than the rated loads for which they are designed.

The BESS 11 is instrumented to provide measurements indicative of its operating state (such as voltage, current and/or temperature) using one or more measuring devices (e.g., sensors). Outputs of the one or more measuring devices may be connected to a data acquisition unit 12.

The data acquisition unit 12 may be or may comprise an analog-to-digital converter, a merging unit, a gateway, without being limited thereto. The data acquisition unit 12 may be provided with a first settings PI, which define a process of converting analog waveforms into discrete signals, specifically a sampling rate and a length of the signal subjected to conversion. The first settings P1 may be fixed or user-specified. The first settings P1 may include a plurality of numerical values.

The data acquisition unit 12 is connected to a computing system 13. The computing system 13 has a data processing unit 14 and communication module 17. In the data processing unit 14, a data storage module 15 and a hybrid data-driven and model-based battery monitoring system module 16 are implemented, which will be described in more detail below.

The data processing unit 14 may also execute additional processes or modules, such as threshold comparisons for comparing current or forecast states of the BESS that cause generation of alarms, warnings, or other outputs, and/or modules for generating and outputting control signals to the BESS 11 and/or devices operatively coupled with the BESS 11 (such as protection system, temperature control systems, etc.).

The data processing unit 14 may use settings P2 and may operate in response to the settings P2. The settings P2 may include or may consist of user inputs. The settings P2 may be supplied to the computing system 13. The settings P2 may be stored in the memory for use in subsequent steps. The computing system 13 may comprise memories, such as read access memory (RAM) and read only memory (ROM).

The computing system 13 may comprise or may be connected to an output unit 18 in which the results of the condition monitoring can be presented to a user. The output unit 18 may comprise an optical output unit, such as a monitor, a printer or any useful device for presentation of the results of the condition monitoring that will be described in more detail herein. Alternatively or additionally to an output unit that may operative as a user interface, the condition monitoring may trigger the generation of control signals that may be output via the communication module 17 to the BESS 11 or devices of the power system associated therewith.

The data acquisition unit 12 may take the form of a dedicated data acquisition system, or may form part of another device with data acquisition capabilities, for example a battery management system (BMS) or a microgrid controller.

The computing system 13 may take the form of a dedicated computer system, or may form part of another device with data acquisition capabilities, for example a battery management system (BMS) or a microgrid controller.

Figure 2 is a block diagram of a computing system 13. The computing system 13 comprises an interface 31 operative to receive measurements (such as voltage, current and/or temperature for the BESS 11). The computing system 13 comprises one or several integrated circuit(s) (IC(s)) 14.

The IC(s) 14 may comprise one or several of a processor, a microprocessor, a controller, a microcontroller, an application specific integrated circuit (ASIC), a field-programmable gate array (FPGA), or a combination thereof.

The IC(s) 14 may be operative to execute a first parameter determination module 32. The first determination module 32 is operative to determine a set of parameter values for a power system asset model (e.g., a BESS model), as a function of measurements received at the interface 31.

The parameterization of the power system asset model may be fixed. For illustration, the power system asset model may include two, three, four or more than four parameters. The parameters may be indicative of characteristics (such as resistances, capacitances, etc.) of an electrical circuit model, mechanical characteristics, chemical characteristics (such as a gas concentration in an insulator oil), or a combination thereof. The power system asset model may be pre-defined, with the determination module 32 determining some or all of the parameter values for the power system asset model.

Measurement values may be received at sampling times at the interface 31. The first determination module 32 may be operative to process measurements (e.g., a voltage and a current) measured time-sequentially and/or received at the interface 31 at time-sequential sampling times into one set of first model parameter values. For illustration, the first determination module 32 may be operative to determine a set of first model parameter values for the parameters of the power system asset model by solving a time-discrete differential equation. Measurements (e.g., a voltage and a current) associated with at least two, at least three or more consecutive sampling times may be processed to respectively determine one set of first model parameter values.

The first determination module 32 repeats the determination of a set of first model parameter values for the power system asset model in a recurrent manner. The determination may be repeated periodically or aperiodically, e.g. in an event-driven manner. Measurements (e.g., a voltage and a current) received at $R \geq 2$ time-sequential sampling times may be processed into one set of first model parameter values for the power system asset model. Measurements (e.g., a voltage and a current) received at R subsequent time-sequential sampling times may be processed into another set of first model parameter values for the power system asset model. This may be recurrently continued. Thus, every set of first model parameter values for the power system asset model is associated with a time or time interval.

Each set of first model parameter values may include a number $n \geq 2$ of parameter values for the n parameters of the power system asset model. The number of parameter values in each set of first model parameter values depends on the parameterization of the power system asset model. One or several of the parameter values may be defined by a user input, in which case these parameter values may, but do not need to be updated based on measurements. For illustration, a nominal battery capacitance or an initial value of a battery capacitance may be specified by an input received from a user. The number of parameter values may be $n \geq 3$, $n \geq 4$, $n \geq 5$, or even greater, depending on the complexity of the power system asset model.

The parameter values in the different sets are assigned to the same parameters, but may vary because the power system asset state, its operating conditions and/or its ambient conditions can vary. The computing system 13 is operative to quantify an evolution of one, several or all of the parameter values included in the sets of first model parameter values for the power system asset model.

The IC(s) 14 may execute a second determination module 33. The second determination module 33 may determine a set of second model parameter values of a parameter evolution model different from the power system asset model. The parameter evolution model describes an evolution of one, several or all first model parameter values of the ESS model.

The second determination module 33 may use different techniques to determine the set of second model parameter values. For illustration, the second determination module 33 may perform a regression analysis for one, several, or all parameter values included in the series of sets of first model parameter values of the power system asset model. The set of second model parameter values may be determined by at least one of machine learning, fitting, or regression analysis, in particular linear regression, using several or all of the determined sets of first of model parameter values as inputs.

By determining the set of second model parameter values (which may be coefficients of a linear regression analysis, weights of a neural network, etc.), the time evolution of the parameter values of the power system asset can be quantified.

The IC(s) 14 may execute an output generation module 34. The output generation module 34 may generate an output based on the series of sets of first model parameter values and the set of second model parameter values. The output may be based on measurements, e.g., when residuals are computed.

The output may include any one or any combination of the following:

- information on current and/or future States of the power system asset
- one or several key performance indicators (KPIs) determined for current and/or future States of the power system asset
- information on a previous, current and/or future performance or remaining useful life (RUL) of the power system asset
- an alarm, warning, or other indicator generated based on previous and/or current and/or future States of the power system asset
- a control signal generated based on previous and/or current and/or future States of the power system asset.

The computing system 13 may be provided locally at or integrated within an enclosure of the power system asset. The computing system 13 may be associated with plural power system assets. Fleet learning may be harnessed by the computing system 13 for determining the set of second model parameter values of the parameter evolution model.

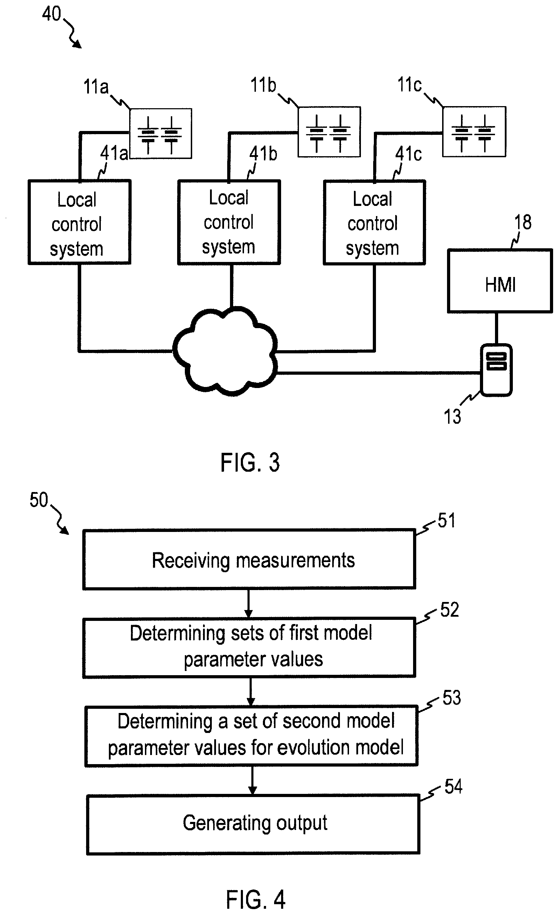

Figure 3 shows a system 40 comprising plural power system assets 11a-11c (in the present case, plural BESSs, without being limited thereto), plural local control systems 41a-41c each associated with one of the power system assets 11a-11c, and a computing system 13 that is communicatively coupled with the plural local control systems 41a-41c. The computing system 13 may be operative to determine

- a series of sets of first model parameter values of a power system asset model for each one of the assets 11a-11c, each of the sets of first model parameter values being determined for a different time or time interval (the parameter values may be different for different ones of the assets 11a-11c even when the same parameterization, i.e., the same power system asset model is used); and
- at least one set of second model parameter values of the parameter evolution model. The parameter evolution model describes an evolution of one, several or all first model parameter values of power system asset model for the assets 11a-11c.

Figure 4 is a flow chart of a method 50 according to an embodiment. The method may be performed automatically by the computing system 13.

At step 51, measurements are received. The measurements may be received at time-sequential sampling times. The measurements represent time-series data.

At step 52, the measurements are processed into a series of sets of first model parameter values of a power system asset model. Each of the sets of first model parameter values may be determined for a different time or time interval. The different time intervals may be overlapping, but do not coincide.

At step 53, the sets of first model parameter values are processed to determine a parameter evolution. The parameter evolution may be modeled by a parameter evolution model. The parameter evolution model may model a time-evolution of one, several or all of the parameter values included in the first model parameter values of the power system asset model. A parameterization of the parameter evolution model may be fixed, and the set of second model parameter values may be determined for the fixed parameterization of the parameter evolution mode. Alternatively or additionally, a parameterization of the parameter evolution model may be determined automatically by the computing system (e.g., by using a machine learning model that accommodates changes in the machine learning architecture, such as by varying a number of hidden layers and/or nodes in each layer of an artificial neural network).

At step 54, output is generated based on the series of sets of first model parameter values and the set of second model parameter values. The output may also depend on the measurements, e.g., by using a residual technique. The output may take any one of the forms discussed elsewhere herein.

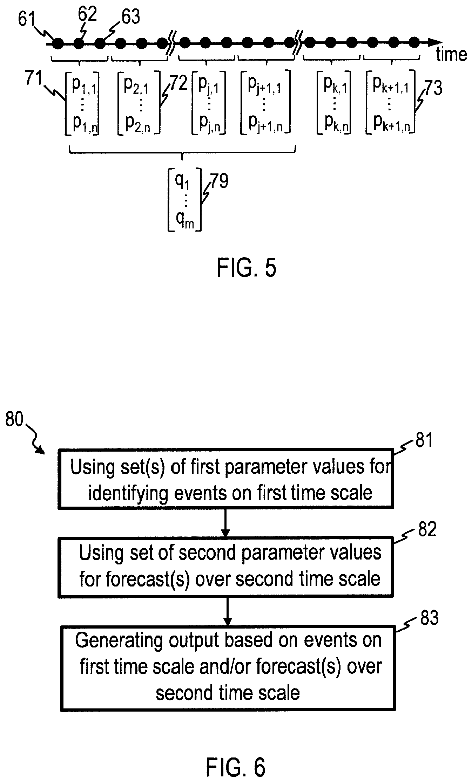

Figure 5 is a diagram illustrating processing of measurements in an embodiment. Each solid circle along the time axis represents measurements at the respective sampling time. Measurements (e.g., battery voltage and current) received at one or several time-sequential (e.g., consecutive) sampling times may be processed into one first set of parameter values.

The power system asset model is parameterized such that it has $n \geq 2$ power system asset model parameters that are determined based on measurements. Parameter values for these n power system asset model parameters are determined based on measurements at one or R time-sequential sampling times. As illustrated in Figure 5, measurements 61-63 received at two, three or more time-sequential sampling times may be processed into one first set of parameter values associated with a time interval defined by the sampling times for measurements 61-63. Each first set of parameter values may generally be an ordered n-tuple denoted as

$$(p_{j,1}, \ldots, p_{j,n}) \tag{1}$$

where j denotes the time or time interval with which the n-tuple is associated.

A first set 71 of parameter values $(p_{1,1}, \ldots, p_{1,n})$ for the power system asset model parameters is determined from the measurements 61-63 at sampling times received in a time interval. Another set 72 of parameter values $(p_{2,1}, \ldots, p_{2,n})$ for the power system asset model parameters is determined from the measurements at sampling times received in another time interval. Yet another set 72 of parameter values $(p_{k+1,1}, \ldots, p_{k+1,n})$ for the power system asset model parameters is determined from the measurements at sampling times received in yet another time interval.

While Figure 5 illustrates a scenario in which each set of parameter values is determined for measurements received during a time interval, with the time intervals being non-overlapping, the time intervals may be overlapping. For illustration, the measurements 62 may be processed both for determining the set 71 and for determining another set 72 of first model parameter values.

Two or more of the sets of first model parameter values 71-73 may be processed to determine a set of second 79 parameter values of the parameter evolution model. The set 79 of second model parameter values may generally be an ordered m-tuple denoted as

$$(q_1, \ldots, q_m) \tag{2}$$

The number m may be less than, equal to, or greater than n. For illustration, if the parameter evolution model is based on linear regression and the time evolution for all n first model parameter values is quantified by the parameter evolution model, m = n. If the parameter evolution model is based on linear regression and the time evolution for only one or only a sub-set of the n first model parameter values is quantified by the parameter evolution model, m < n. If more complex techniques are used (such as non-linear regression models, machine learning where the number of weights between nodes of the artificial neural network exceeds n), the number m of second model parameter values may exceed the number n of first model parameter values in each set.

As illustrated in Figure 5, the set 79 of second model parameter values does not need to be determined based on all available sets 71, 72, 73 of first model parameter values. The set 79 of second model parameter values may be recurrently updated as new sets of first model parameter values are determined.

In an illustrative implementation, the set 79 of second model parameter values may represent coefficients of a linear or non-linear function of time. It is understood that time may be measured in a discrete manner, e.g., by a discrete index that can label the time of the first measurement 61 that is processed into the respective first set 71 of parameter values, etc.

Determining the set 79 of second model parameter values may comprise determining functions $F_i$ in such a manner that a target function becomes minimum or maximum. The set 79 of second model parameter values may comprise determining functions $F_i$ in such a manner that

$$\sum_{j \in J} \left\| p_{i,j} - F_i(j) \right\| \tag{3}$$

becomes minimum, where i is a label for the respective parameter value (e.g., a resistance or capacitance value of a circuit model of the power system asset), j is a discrete index representing time, J is a (sub-)set of times or time intervals for which the set of first model parameter values has been determined, and $\| \cdot \|$ denotes a norm, such as an L2 norm, without being limited thereto.

Equation (3) allows the functions $F_i(j)$ to be determined independently for each parameter i of the power system asset model, more complex approaches may be used, e.g., when different parameters can be correlated. For illustration, determining the set 79 of second model parameter values may comprise determining functions $F_i$ in such a manner that

$$\sum_{i \in I} \sum_{j \in J} \left\| p_{i,j} - F_i(j) \right\| \tag{4}$$

becomes minimum, where I denotes the (sub-)set of the n power system asset model parameters for which the time evolution is to be determined.

A regularization term and/or a penalty term imposing constraints may be added to the target functions of equations (3) and (4).

The functions $F_i(j)$ may be linear functions, non-linear polynomials, or other functions of j. The functions $F_i(j)$ will generally be different for different i.

When the functions $F_i(j)$ are linear functions, the set 79 of second model parameter values $q_i$ may be determined in such a manner that a target function

$$\sum_{j \in J} \| p_{i,j} - p_{i,1} - q_i \times (j-1) \| \qquad (5)$$

or

$$\sum_{i \in I} \sum_{j \in J} \| p_{i,j} - p_{i,1} - q_i \times (j-1) \| \qquad (6)$$

becomes minimum. In this case, the second model parameter values $q_i$ of the parameter evolution model may be regression coefficients of a linear regression analysis. In an exemplary implementation, the target function may be evaluated based on all available sets of first model parameter values (i.e., $j = 1, ... j_r$), where $j_r$ is the most recent time or time interval for which the set of first model parameter values has been determined). Other approaches may be used, such as by performing smoothing, eliminating outliers etc.

Efficient techniques for solving the extremum-finding problems of equations (3)-(6) with or without regularization are known. The set 79 of second model parameter values may be determined based on an iterative numerical approach that identifies a minimum or maximum of an objective function, as explained with reference to equations (3) to (6).

The parameter evolution model and, more specifically, the determined set of second model parameter values may be used in various ways. The set of second model parameter values may be used to quantitatively assess changes in power system asset state that occur over a time period that is longer, in particular much longer than a time interval after which a new set of first model parameter values 71, 72, 73 is being determined.

The set of second model parameter values may be used to determine a forecast of future power system asset states, a remaining useful life (RUL), a future performance, a future performance degradation, future KPIs, future KPI degradation, without being limited thereto. The set of second model parameter values may be used to provide prognostic information to a user via a user interface and/or to initiate appropriate counter-measures before a performance degradation occurs (e.g., by providing alarms, warning, or prognostic information to the user or by automatically generating control signals).

The set of second model parameter values may be determined not only for one, but for various different operational and/or ambient conditions. This allows the prognostic information to be determined for various different operational and/or ambient conditions. In order to determine a set of second model parameter values for various different operational and/or ambient conditions, the computing system 13 may trigger an intermittent change in operational and/or ambient conditions (e.g., by causing a temperature control unit in an enclosure of the power system asset to temporarily increase or decrease the temperature), determine at least two sets of first model parameter values while the operational and/or ambient conditions is adjusted in such a manner, and determine a set of second model parameter values associated with the adjusted operational and/or ambient conditions based thereon.

Figure 6 is a flow chart of a method 60. The method 60 may be performed automatically be the computing system 80.

At step 81, one or several set(s) of first model parameter values are used for identifying events that occur on a first time scale. The first time scale may correspond to a sampling interval, i.e., the time interval between receipt of successive measurements.

Identifying events that occur on the first time scale may comprise computing an observable based on the one or several set(s) of first model parameter values, and comparing the computed observable to a measurement. A threshold comparison may be performed on the deviation. A deviation between the computed observable that is based on the power system asset model and the actual measurement is indicative of a sudden event that occurs on the first time scale. Such a deviation may trigger an immediate action, such as an outputting of an alarm, warning, status information, or control signal.

At step 82, the set of second model parameter values is used to determine forecast(s) for the power system asset state over a second time scale that exceed the first time scale. The second time scale may be longer than the time interval at which a new set of first model parameter values is computed.

Step 82 may comprise further processing. For illustration, a RUL or other KPIs may be prognostically determined. This may optionally be done for various operational and/or ambient conditions, using the sets of second model parameter values determined for various operational and/or ambient conditions. Suggested control actions that enhance the RUL or that slow down a degradation of other KPIs may be automatically determined (e.g., by identifying operational and/or ambient conditions that are optimum with regard to mitigating future performance degradation while meeting desired performance of the power system asset).

At step 83, output is generated and provided based on the events identified over the first time scale and/or the forecast(s) that occur over the longer second time scale.

For further illustration, reference will be made to a rechargeable ESS, in particular to a BESS in the following. It will be appreciated that the disclosed techniques are similarly applicable to other power system assets.

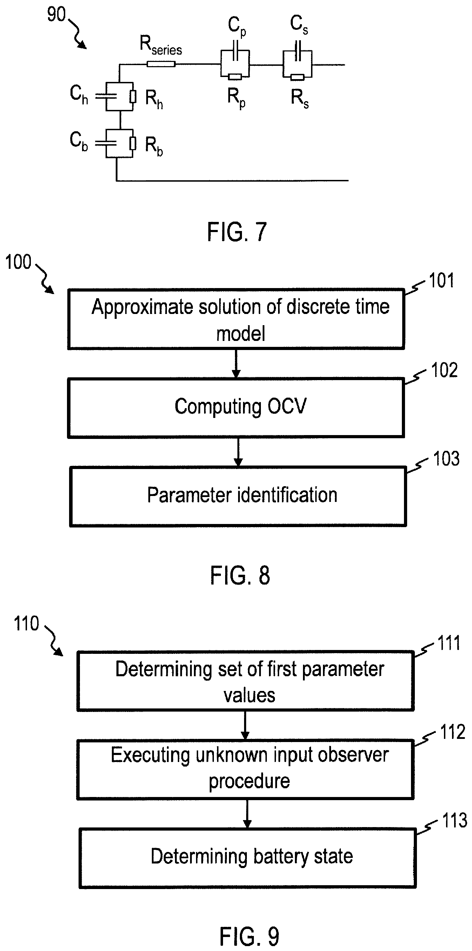

Figure 7 is an exemplary model circuit diagram 90 of a BESS. The circuit 90 is composed of an ohmic resistance $R_{series}$ and four RC elements which model the following:

- Battery: The ability of the battery to store energy is modelled as a capacitor $C_b$. $R_b$ denotes a self-discharge resistance of the battery.
- Hysteresis effect: Hysteresis is modelled as an RC circuit with resistance $R_h$ and capacitance $C_h$ to introduce nonlinear differences between open circuit voltage (OCV) during charging and discharging for the same state of charge (SOC) of the battery.
- Long-time dynamic element: RC element containing $C_p$ and $R_p$ introduces the long-time transients of the battery.
- Short-time dynamic element: RC element containing $C_s$ and $R_s$ introduces the short-time transients of the battery.

The capacitance $C_b$ may be taken from name plate data (battery capacity in kWh) of the BESS. The capacitance $C_b$ is larger than $C_h$, $C_p$, and $C_s$. Other models, in particular less complex models having a smaller number of parameter may be used.

Figure 8 is a flow chart of a method 100. The method 100 may be performed automatically to determine the parameter values of the BESS model.

At step 101, an approximate solution of a discrete time model may be determined. This may comprise solving a linear differential equations. For illustration, in response to measured voltages and currents determined for times $j=k$, $k-1$, and $k-2$, the values for $\theta_1, , _6$ may be numerically determined such that

$$V_{meas}[k] = (\theta_1 \quad \theta_2 \quad \theta_3 \quad \theta_4 \quad \theta_5 \quad \theta_6) \begin{pmatrix} V_{meas}[k-1] \\ V_{meas}[k-2] \\ I_{meas}[k] \\ I_{meas}[k-1] \\ I_{meas}[k-2] \\ 1 \end{pmatrix} \qquad (7)$$

where $V_{meas}[j]$ denotes the measured voltage and $I_{meas}[j]$ denotes the measured current at time j.

At step 102, when $\theta_1, , _6$ have been determined, the OCV can be determined therefrom. This may be done using the techniques of X. Tang et al., "Li-ion Battery Parameter Estimation for State of Charge," in American Control Conference, San Francisco, 2011, without being limited thereto.

At step 103, $\alpha_1, ..., _6$ are determined. The OCV of step 102 is used as one of the variables of the linear differential equation, following, e.g., G. Aggoun et al., "SOC Estimation Based on OCV and Online Identification Parameters Of Lithium Ion Batteries with ADALINE," in 8th International Conference on Modelling, Identification and Control, Algiers, 2016. For illustration, $\alpha_1, , _6$ may be determined such that

$$V_{meas}[k] = (\alpha_1 \quad \alpha_2 \quad \alpha_3 \quad \alpha_4 \quad \alpha_5 \quad \alpha_6) \begin{pmatrix} OCV \\ V_{meas}[k-1] \\ V_{meas}[k-2] \\ I_{meas}[k] \\ I_{meas}[k-1] \\ I_{meas}[k-2] \end{pmatrix} \qquad (8)$$

From $\alpha_{1, ..., 6}$, resistances and/or capacitances of the BESS model may be determined. For illustration, $R_{series}$, $R_p$, $C_p$, $R_s$, and $C_s$ may be determined. The techniques of X. Tang et al., "Li-ion Battery Parameter Estimation for State of Charge," in American Control Conference, San Francisco, 2011 may be used, without being limited thereto.

The determined set of first model parameter values of the BESS model allow a current battery state to be estimated. This may include determining a SOC or state of health (SOH).

For example, a measured terminal voltage can be considered as the input to the BESS model, for which the parameter values have previously been determined. The BESS model can then be used estimate the current, open circuit voltage, and voltage drops across the battery.

An unknown input observer can be used for estimating a current in a battery for known terminal voltages and parameters. An exemplary technique that can be used is described in D. C. Cambron et al., "A lithium-Ion Battery Current Estimation Technique Using an Unknown Input Observer," IEEE, 2017.

Figure 9 is a flow chart of a method 110 that may be used to determine an observable for a current BESS state. The method 110 may be performed automatically by the computing system 13. The method 110 may be used to compute an observable in step 81 of the method of Figure 6.

At step 111, a set of first model parameter values for the BESS model is determined. This may be done as described with reference to Figure 8.

At step 112, an unknown input observer procedure is performed to estimate a battery current in a for known terminal voltages and BESS model parameters. Other observables may be determined.

At step 113, a battery state may be estimated that includes the estimated battery current. Observables included in or derived from the battery state (such as battery current) may be compared to measurements to identify sudden events.

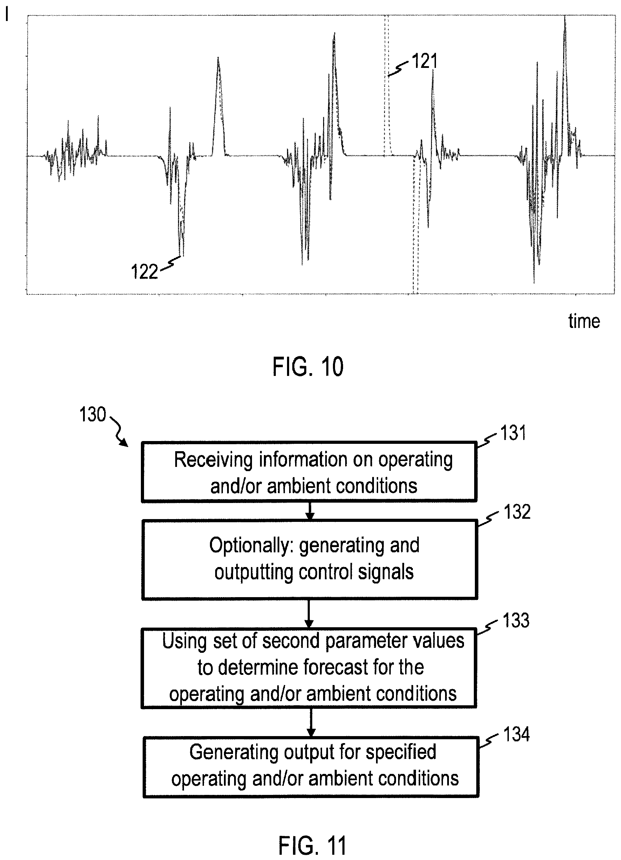

Figure 10 is a graph that shows how computed observables derived from or included in the BESS state may be used to identify sudden events. Figure 10 shows a measured battery current 121 as broken line and an estimated battery current 122 as solid line. The estimated battery current 122 is computationally determined, following the techniques described with reference to Figures 4 to 9. While the measured battery current 121 and the estimated battery current 122 coincide, up to minor deviations, in certain situations, there will be more pronounced deviations between the two quantities in some time intervals. Such pronounced deviations are indicative of a sudden event and may trigger the outputting of a warning, alarm, status information, or control signal by the computing system 13.

The techniques described with reference to Figures 1 to 10 may be used to systematically assess different long-term behavior of a BESS or other power system asset. This may be done for various operating conditions and/or ambient conditions. Providing information on a forecast for the RUL or other KPIs not only for one specific operating condition and ambient condition, but for various operating conditions and/or ambient conditions aids in the selection of suitable operating conditions and/or ambient conditions that mitigate power system asset degradation.

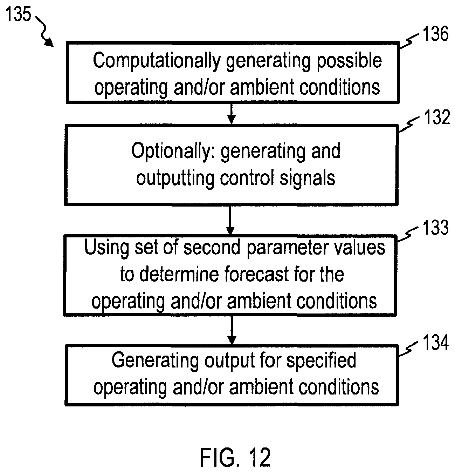

Different operating conditions and/or ambient conditions may be explored in various ways. Information on operating conditions and/or ambient conditions input via a user interface may be received, and the computing system 130 may automatically determine the set of second model parameter values for the specified operating conditions and/or ambient conditions. Alternatively or additionally, the computing system 130 may determine the set of second model parameter values respectively for each of various operating conditions and/or ambient conditions and may output information on KPIs (such as a RUL) and/or suggested control actions for the various operating conditions and/or ambient conditions. These techniques will be explained in more detail with reference to Figures 11 and 12.

Figure 11 is a flow chart of a method 130. The method 130 may be performed automatically by the computing system 13.

At step 131, information on one or several operating condition(s) and/or ambient condition(s) is received. The information may be received via a user interface. The information on the operating condition(s) may specify a charging or discharging current, a depth of discharge, or other information relating to operation of the BESS. The information on ambient condition(s) may specify an ambient temperature in an enclosure in which the BESS is housed.

At step 132, the computing system 13 may optionally generate and output control signals. The control signal(s) may be generated to at least intermittently adjust an operating condition and/or ambient condition in accordance with the information received at step 131. The control signals may be generated selectively only if the set of second model parameter values has not been determined for the operating and/or ambient conditions specified at step 131, or if no set of second model parameter values has been determined for operating and/or ambient conditions that are similar to those specified at step 131.

The control signals may be generated to at least intermittently adjust an operating parameter (e.g., a charge rate, discharge rate, depth of discharge, a protection system state) and/or an ambient parameter (e.g., a temperature in an enclosure of the power system asset and/or an air humidity) in accordance with the operating condition and/or ambient conditions specified at step 131.

While the operating condition and/or ambient condition are adjusted in accordance with the information received at step 131, measurements may be processed into at least two sets of first model parameter values for the power system asset model that are associated with two sequential times or time intervals. A set of second model parameter values of a parameter evolution model may be determined for these adjusted operating condition and/or ambient condition based on these at least two sets of first model parameter values for the power system asset model.

When several different operating conditions (e.g., different charge and/or discharge rates, different depths of discharge, different protection system states) and/or ambient conditions (e.g., different temperatures) are specified at step 131, the control signals at step 132 may be generated to sequentially adjust operating and/or ambient parameters of the power system asset in accordance with the different operating conditions and/or ambient conditions specified at step 131. At least two sets of first model parameter values for the power system asset model and a set of second model parameter values of the parameter evolution model may thus be determined for each operating condition and/or ambient condition specified at step 131.

At step 133, the set(s) of second model parameter values may be used to compute a forecast of a future evolution of the power system asset model parameter values or quantities derived therefrom, such as a RUL or other KPIs, respectively for each one of the various operating and/or ambient conditions.

At step 134, an output may be generated. The output may include information on the future evolution of the power system asset model parameter values or quantities derived therefrom, such as a RUL or other KPIs, respectively for each one of the various operating and/or ambient conditions specified at step 131.

The computing system 13 may use the forecasts to identify most suitable operating and/or ambient conditions. For illustration, the computing system 13 may automatically process the forecasts to determine which one of the operating conditions and/or ambient conditions maximizes one or several KPIs, such as RUL. The computing system may generate and output information on these operating conditions and/or ambient conditions, and/or may provide information on suggested control actions that maximize one or several KPIs.

Figure 12 is a flow chart of a method 135. The method 135 may be performed automatically by the computing system 13.

At step 136, possible operating and/or ambient conditions of the power system asset may be automatically generated by the computing system. For illustration, the computing system may automatically generate a set of charge and/or discharge rates, power system asset ambient temperatures, etc.

At steps 132-134, a set of second model parameter values may be determined for each of the operating and/or ambient conditions generated at step 136. The computing system 13 may generate and output control signals to intermittently change the operating and/or ambient conditions of the power system asset, so as to determine a set of second model parameter values of the parameter evolution model for each of the possible operating and/or ambient conditions generated at step 131. At step 134, the computing system 13 may use the sets of second model parameter values that are associated with different operating and/or ambient conditions to output information on a RUL or other KPIs for each of the ambient and/or operating conditions determined at step 136, or to automatically identify most suitable operating and/or ambient conditions. For illustration, the computing system 13 may automatically process the sets of second model parameter values that are associated with different operating and/or ambient conditions to determine which one of the operating conditions and/or ambient conditions maximizes one or several KPIs, such as RUL. The computing system may generate and output information on these operating conditions and/or ambient conditions, and/or may provide information on suggested control actions that maximize one or several KPIs.

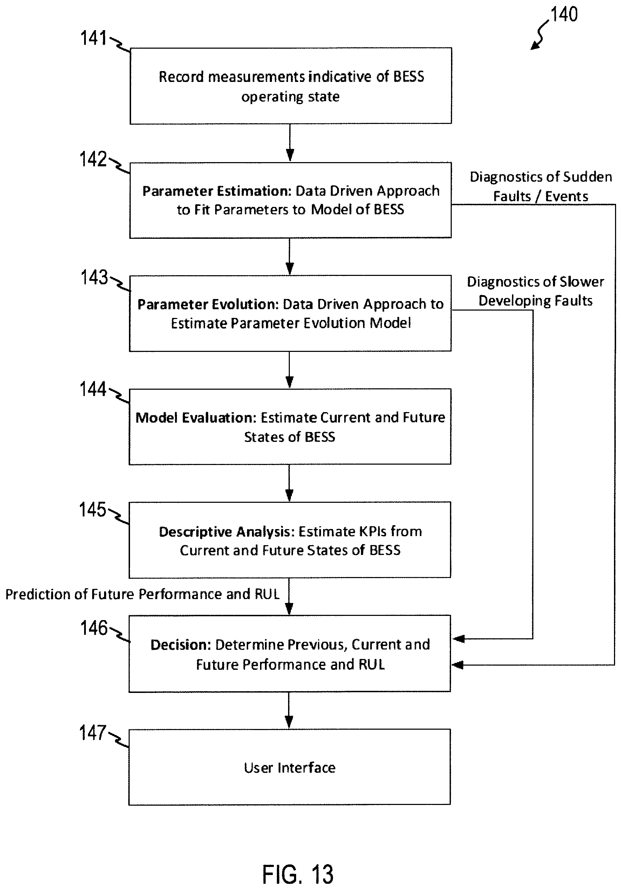

Figure 13 is a flow chart of a method 140. The method 140 may be performed automatically by the computing system 13. The method 140 is explained in association with a power system asset that is a BESS, without being limited thereto.

At step 141, measurements indicative of the BESS operating state are received.

At steps 142-147, the measurements are processed. A hybrid of data-driven and model-based approaches may be used.

At step 142, a parameter estimation is performed. Data measured from the BESS system is used to identify the parameter values of the BESS model which may subsequently be used to determine a system state. As explained elsewhere herein, determining the parameter values of the BESS model may comprise determining values of resistances and capacitances of a circuit model of the BESS.

At step 143, a parameter evolution is determined. A mathematical model describing the evolution of the parameter values of the BESS model with respect to external factors (e.g. temperature, time, cycling, load etc.) may be trained on the basis of the parameters estimated in step 142 and, optionally, additional historical values stored in a database. The mathematical model describing the evolution of the parameter values of the BESS model is also referred to as parameter evolution model.

At step 144, a model evaluation may be performed. The BESS model and the parameter evolution model are employed to estimate current and future values of battery parameters and battery state (e.g. voltage drops including open-circuit voltage and current flowing across the battery circuit) on the basis of current and predicted future measurements. Future measurements may be estimated on the basis of various operation scenarios provided by a user or automatically generated by the computing system. Examples of such scenarios include assuming previous operating trends continue into the future, or defining changes in operation (e.g. temperature control, circuit breaker states, charge/discharge rate etc.). When a user select a desired scenario for execution, the system references the needed control signals to the control units in order to track the projected scenario.

At step 145, a descriptive analytics is executed. The descriptive analytics makes use of the current and future states that are estimated at step 144. Here, predicted SOH (indicator of remaining capacity) and ohmic resistance (indicator of power fading) may be employed to estimate the remaining useful lifetime RUL of the battery. RUL is estimated for every operation scenario (provided by the user or by the computing system itself). Other KPIs which are indicative of BESS performance (e.g. SoC, efficiency, etc.) are also calculated for the current and future states. At step 145, residuals comparing the outputs predicted by the BESS model for the current inputs with the measurements observed in the physical system are calculated.

At step 145, a decision layer procedure is executed. In the decision layer, the outputs from steps 142-145 are processed in order to calculate alarms, warnings and/or suggested actions that may be output to the user. The residuals comparing the outputs predicted by the BESS model for the current inputs with the measurements observed in the physical system are used to identify any sudden discrepancies between the model and the real system (e.g. due to sudden faults). The trends of the evolution of the parameters of the mathematical model of the BESS system are used to establish general degradations in the system (e.g. capacitor or power fading). If the degradation is too large, e.g. based on a threshold comparison, an alarm is flagged to the user. The decision layer for performance may be used to calculate the most likely values of key performance indicators (e.g. efficiency) as well as confidence bounds for different operating scenarios. The decision layer for lifetime estimation may be used to calculate the most likely remaining useful lifetime, as well as confidence intervals, for the BESS system for different operating scenarios. The outputs of the decision layer at step 146 is conveyed to the end user via a user interface at step 147.

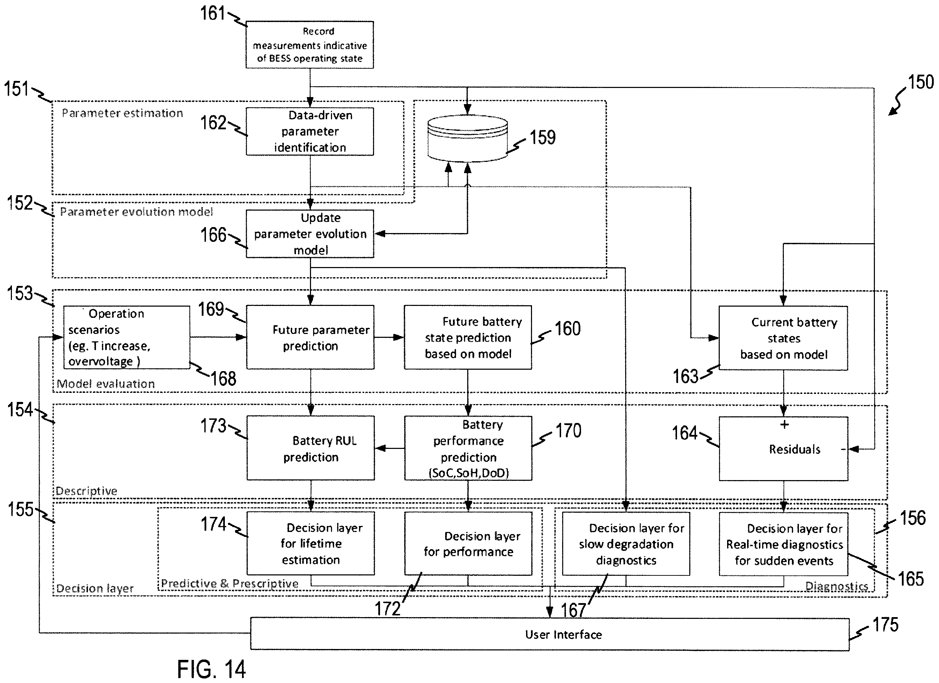

Figure 14 shows a detailed realization of a method according to an embodiment. The method may be automatically performed by the computing system 13.

At step 161 measurements indicative of BESS operating state are measured and acquired. Typical examples of relevant measurements include voltage, current and temperature.

At step 162 the measurements recorded at Step 161 are used to estimate the values of parameters of the BESS model using conventional techniques, such as least squares.

System identification is a starting point realized by taking as inputs the measured voltage and current, as explained with reference to Equations (7) and (8) and Figure 8. A discrete time model of lithium-ion batteries can be expressed in the form of a linear difference equation, as explained with reference to Equation (7). Once the parameters of vector $\theta$ are fitted, the OCV is calculated. OCV is then used as the input for the second block, this time using it as one of the variables of the linear difference equation, as explained with reference to Equation (8). Techniques such as those described by X. Tang et al., "Li-ion Battery Parameter Estimation for State of Charge," in American Control Conference, San Francisco, 2011 and G. Aggoun et al., "SOC Estimation Based on OCV and Online Identification Parameters Of Lithium Ion Batteries with ADALINE," in 8th International Conference on Modelling, Identification and Control, Algiers, 2016 may be used.

A window of data points (i.e. vectors of multiple sample points for each measurement signal) and/or a periodicity of fitting the parameters (i.e. how often the parameter estimation is performed) may be tuned by the user using settings P2.

At step 163 one or more measured model inputs, recorded at step 161 are used as input to the model with fitted BESS model parameter values output from step 162 in order to estimate the current battery state. For example, a measured terminal voltage might be considered as the input to the model. The BESS model will then estimate the current, open circuit voltage, and voltage drops across the battery.

For example an unknown input observer can be used for estimating the current in a battery for known terminal voltages and parameters, as explained with reference to Figure 9. The processing techniques of D. C. Cambron et al., "A lithium-Ion Battery Current Estimation Technique Using an Unknown Input Observer," IEEE, 2017 can be used.

At step 164 one or more measured outputs, estimated by the BESS model are compared with corresponding measured values. For example, with reference to Figure 10, the current measured from the BESS may be subtracted from the current estimated by the BESS model in order to obtain residuals indicative of the different between the modelled and true behavior.

At step 165 the residuals calculated at step 164 are processed in order to identify sudden changes / events in the system that may be indicative of a sudden fault. In an example implementation, the residuals may be compared against alarm threshold limits set by the user in settings P2. If the residual exceeds either an upper or lower alarm threshold limit, an alarm is passed to the user (step 175). If a residual is exceeded then a root cause analysis may be performed. This may take the form of an expert system (e.g. if the terminal voltage exceeds the open circuit voltage, the battery may be considered as over charged).

Steps 161-165 may be considered to represent a procedure for performing diagnostics of events that occur on a first, shorter time scale. Such events are also referred to as sudden events.

Measurements recorded at step 161 and parameters estimated at step 162 are stored in a historian 159.

At step 166, a data-driven model of how parameters evolve with respect to operating conditions and/or external factors is trained using data from the historian 159. This comprises determining a set of second model parameter values of the parameter evolution model. The parameter evolution model may take into account other measurements not employed during the identification of the parameters (e.g. temperature). Various approaches for estimating the evolution of model parameters with respect to input parameters may be utilized, for example neural networks, or regression. Parameters of a mathematical model including calendar and cyclic aging effects can be fitted using historical data.

As in step 162, it may be noted that a window of data points (i.e. vectors of multiple sample points for each measurement signal) and the periodicity of fitting the parameters (i.e. how often the parameter estimation is performed) may be tuned by the user using settings P2.

The values and trends of the parameters of the BESS calculated at steps 162 and 166 are used as input to step 167. At step 167 these parameters are processed to identify slowly evolving changes that occur over a second time scale longer than the first time scale. The slowly evolving changes / events in the system may be indicative of degradation. In an example implementation, the parameter values of the parameter evolution model (i.e., one or several parameter values included in the set of second model parameter values) may simply be compared against alarm threshold limits set by an alarm is passed to the end user (step 175). For example capacitor fading may be identified by a decrease in the capacity of the battery to store energy and increases in ohmic resistance are indicative of power fading.

Steps 161-167 may be considered a procedure for performing diagnostics of slowly evolving changes, such as degradation.

At step 168 one or more operational scenarios are defined. A default scenario is to assume that the current operating trends continue into the future. Optionally, the user may define other operating scenarios such as changes in temperature control settings, circuit breaker states, charge/discharge rate etc. These operating scenarios are passed to the system as part of settings P2 and are translated into model inputs (e.g. voltage operating profiles) that are passed to step 169. The model inputs may also take the form of a Monte Carlo simulation (i.e. the probability of particular operating scenarios might be considered and simulated multiple times in order to generate ranges of parameters).

Along with the parameter evolution model calculated at step 166, the operating scenarios, translated into model inputs at step 168 are passed to step 169. In step 169 the future parameter values of the BESS model are predicted for the operating scenarios using the parameter evolution model.

In step 170 the future states of the BESS system are estimated using the future parameter values of the BESS model estimated at Step 169. The model evaluation methods described for step 163 may be used to perform the estimation. These values are passed to step 171 where the future performance of the battery is estimated. This evaluation can take the form of determining key performance indicators (KPIs), such as State of Charge, State of Health, Efficiency, etc. which may be calculated from the estimated future values of current and voltage. These future KPIs are passed to step 172 where the most likely future KPI values for each operating scenario, as well as the associated variances may be calculated. This information is passed to the end user (step 175).

Steps 161-172 may be considered the steps for predicting future performance of the BESS for various operating scenarios.

In step 173 the future KPIs calculated at step 171 and the associated future values of parameters of the BESS model calculated at step 169 are used as inputs to a RUL estimation step 173. Predicted SOH (indicator of remaining capacity) and ohmic resistance (indicator of power fading) may be employed to estimate the remaining useful lifetime RUL of the battery. RUL is estimated for every operation scenario. Furthermore, the likelihood of fault for a given operating scenario might also be calculated using methods known in the state of the art (e.g. Bayesian inference, expert knowledge etc.). The RUL estimated for every operation scenario is passed to step 174 where the most likely future RUL values for each operating scenario, as well as the associated probability is calculated. This information is passed to the end user (step 175).

Steps 161-174 may be considered a procedure for predicting the RUL of the BESS for various operating scenarios.

At step 175 the user is provided with information about the previous and current performance and health of the BESS and is also provided with projections of battery RUL and performance, for different scenarios. Using this decision support information, the user is able to select a desired scenario which may be translated to control signals or maintenance plans (not depicted here). The user may also define different operating scenarios to be tested, feeding back the scenarios to step 168.

Alternatively or additionally to allowing the user to define operating scenarios, a multi-objective optimization approach can be executed to automatically select an optimum strategy in terms of maximizing user defined objectives (e.g. maximize future availability, maximize efficiency etc.).

As explained with reference to Figures 13 and 14, processing of measurements may be performed in various layers. This may include a parameter estimation layer 151 at which the parameter values for a BESS model are determined; a parameter evolution model layer 152 at which a parameter evolution model is trained; a model evaluation layer 153 at which future BESS model parameter values and/or future BESS states are predicted; a descriptive layer 154 at which residuals between computed observables and measurements are determined (step 164) and/or at which performance and/or RUL prediction is performed (steps 173 and 170); a decision layer 155 at which various decisions may be taken, and which may include a diagnostics layer 156 for identifying events that occur on a first time scale (e.g., sudden events due to faults) and trends that occur over a second longer time scale (e.g., a degradation process).

The methods may be used for a rechargeable battery of a BESS with available voltage, current and temperature measurements from a cell level or cell string level. The disclosed methods may be implemented for every cell or every cell string in the BESS.

The battery may be a lithium-ion battery or another battery type.

The results from multiple cells, racks, batteries in the BESS can be combined with other similar models for other elements in the system. The results of all elements can be combined at the user interface in order to provide a holistic overview of the BESS.

Instead of or in addition to sending parameters, and residuals to a user interface, the information may be passed to a cloud infrastructure, allowing parameters and behaviors across a fleet of devices to be evaluated.

Devices and systems according to embodiments can be applied to any BESS. Devices and systems according to embodiments can be applied to, e.g., BESSs having powers of 1 MW or more, e.g., 2 MW or more, e.g. 5 MW or more, without being limited thereto.

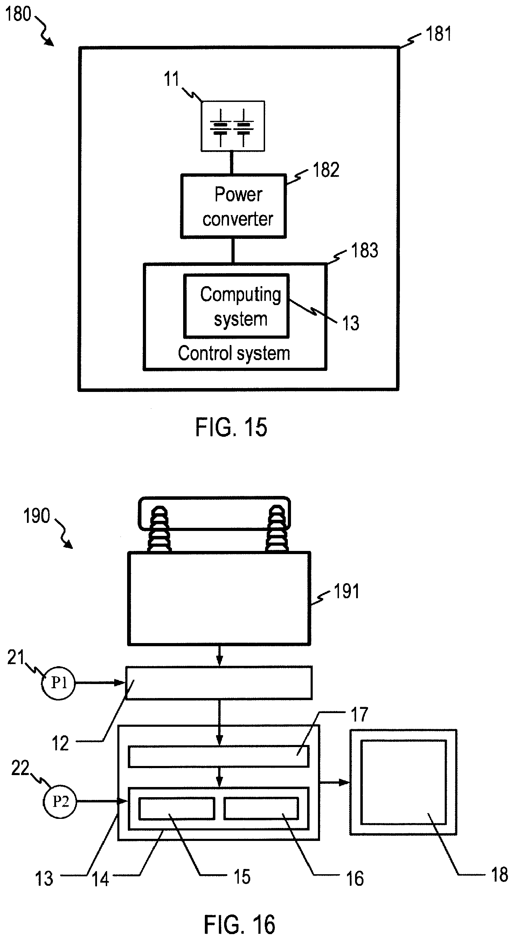

The computing system 13 may be integrated into a BESS, as illustrated in Figure 15.

Figure 15 shows a BESS system 180. The BESS system 180 comprises an enclosure 181. At least one rechargeable battery 11 is provided in the enclosure 181. The enclosure may be rack, container, or other enclosure.

The BESS system 180 comprises a power converter 182. The power converter 182 may be arranged in the enclosure 181.

The BESS system 180 comprises a control system 183. The control system 183 may be or may comprise a battery management system (BMS). The control system 183 may be arranged in the enclosure 181.

The computing system 13 according to the invention may be integrated with or coupled to the control system 183. The computing system 13 may be arranged in the enclosure 181.

In a BESS system 180 as shown in Figure 15, functions such as forecasting, diagnostics of short-term events and longer-term degradation may be integrated into a unitary solution that has one or several rechargeable batteries 11, associated converter(s) 182, and control system 183 housed in a common housing or enclosure.

While methods and devices are applicable to rechargeable energy storage systems, such as rechargeable lithium-ion batteries, they are not limited thereto. For illustration, the disclosed techniques may be applied to other power system assets or industrial assets.

Figure 16 shows a system 190 comprising an asset 191 and a computing system 13. The computing system 13 is operative to receive, from at least one data acquisition unit 12, measurements indicative of a state of the asset 191. The computing system 13 is operative to process the received measurements to determine a series of sets of first model parameter values of a power system asset model. Each of the sets of first model parameter values is determined for a different time or time interval. The computing system 13 is operative to determine, using the series of sets of first model parameter values, a set of second model parameter values of a parameter evolution model different from the power system asset model. The parameter evolution model describes an evolution of one, several or all first model parameter values of the power system asset model. The computing system 13 is operative to generate and provide an output in dependence on at least one of the sets of first model parameter values of the power system asset model and the set of second model parameter values of the parameter evolution model.

The asset 191 may be a transformer. The power system asset model may be a transformer model. Determining the set of second model parameter values may comprise determining a rate of change of transformer characteristics related to an insulation, winding, or bushing of the transformer. For illustration, the transformer 191 may have an insulation system having an insulation fluid (e.g., an insulation oil). The set of second model parameter values may comprise a value of a parameter indicating a rate of change of concentration(s) of gas(es) dissolved in the insulation fluid.

While the invention has been described in detail in the drawings and foregoing description, such description is to be considered illustrative or exemplary and not restrictive. Variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality. The mere fact that certain elements or steps are recited in distinct claims does not indicate that a combination of these elements or steps cannot be used to advantage, specifically, in addition to the actual claim dependency, any further meaningful claim combination shall be considered disclosed.

**Claims**

1. A method of monitoring and/or operating a power system asset (11; 11a-c), the method comprising the following steps:

receiving, from at least one data acquisition unit (12), measurements indicative of a state of the power system asset (11; 11a-c);
processing the received measurements to determine a series of sets of first model parameter values (71-73) of a power system asset model, each of the sets of first model parameter values (71-73) being determined for a different time or time interval;
determining, using the series of sets of first model parameter values (71-73), a set of second model parameter values (79) of a parameter evolution model different from the power system asset model, the parameter evolution model describing an evolution of one, several or all first model parameter values (71-73) of the power system asset model; and

generating and providing an output in dependence on at least one of the sets of first model parameter values (71-73) of the power system asset model and the set of second model parameter values (79) of the parameter evolution model.

2. The method of claim 1, wherein the parameter evolution model describes the evolution of one, several or all first model parameter values (71-73) of the power system asset model as a function of operating conditions and/or ambient conditions.

3. The method of claim 1 or claim 2, wherein generating the output comprises performing degradation diagnostics using the parameter evolution model, wherein the output is generated as a function of a result of the degradation diagnostics.

4. The method of any one of the preceding claims, further comprising using the parameter evolution model to generate a forecast for a future evolution of the one, several or all first model parameter values (71-73) of the power system asset model.

5. The method of claim 4, wherein the forecast is used to generate an output that comprises at least one of the following:

a remaining useful life, RUL, based on the forecast future evolution;
a future power system asset state;
a future performance of the power system asset.

6. The method of claim 4 or claim 5, wherein the parameter evolution model describes the evolution of one, several or all first model parameter values (71-73) of the power system asset model as a function of ambient conditions and/or operating conditions, and the method comprises using the parameter evolution model to generate several forecasts for a future evolution of the one, several or all first model parameter values (71-73) of the power system asset model, the several forecasts being determined for different future ambient conditions and/or operating conditions.

7. The method of claim 6, further comprising receiving user input specifying at least a sub-set of the future ambient conditions and/or operating conditions, and/or automatically generating at least a sub-set of the future ambient conditions and/or operating conditions.

8. The method of any one of the preceding claims, comprising:

using the power system asset model to perform diagnostics for events that happen on a first time scale, and using the parameter evolution model to identify trends that happen on a second time scale, the second time scale exceeding the first time scale.

9. The method of claim 8, wherein at least one of the sets of first model parameter values (71-73) of the power system asset model is used in combination with measurements to compute a current power system asset state, to compute residuals between measurements and observables estimated from the current power system asset state, and to perform diagnostics for events that happen on the first time scale based on the residuals.

10. The method of any one of the preceding claims, wherein the output comprises one or several of:

information output via a human machine interface (18), HMI, optionally comprising power system asset health information, optionally comprising an alarm or warning;
control signals that are output to a controller, in particular a battery management system, BMS, or microgrid controller (41a-c), optionally wherein the control signals control at least one of charge rate, discharge rate, power system asset ambient temperature, depth of discharge, a protection system.

11. The method of any one of the preceding claims, wherein the power system asset is or comprises a rechargeable energy storage system, ESS, in particular an electro-chemical ESS, in particular a rechargeable battery energy storage system (11; 11a-c), BESS.

12. The method of claim 11, wherein the ESS comprises a plurality of cells or a plurality of cell strings, and wherein the sets of first model parameter values (71-73) and the set of second model parameter values (79) of a parameter evolution model are determined separately for each of the plurality of cells or cell strings.

13. The method of any one of the preceding claims, wherein

determining a set of first model parameter values (71-73) comprises solving a discrete-time linear differential equation; and/or
determining the set of second model parameter values (79) comprises at least one of machine learning, fitting, regression analysis, in particular linear regression;
optionally wherein the set of first model parameter values (71-73) comprises parameter values for

a self-discharging resistance ($R_b$);
a first RC element ($R_h$, $C_h$) to model hysteresis for charging and discharging;
a second RC element ($R_p$, $C_p$) to model long-time transients;
a third RC element ($R_c$, $C_c$) to model short-time transients.

14. A computing system, comprising:

an interface (17; 31) operative to receive measurements indicative of a state of a power system asset (11; 11a-c); and
at least one integrated circuit (14) coupled to the interface (17; 31) and operative to

process the received measurements to determine a series of sets of first model parameter values (71-73) for a power system asset model, each of the sets of first model parameter values (71-73) being determined for a different time or time interval,
determine, using the series of sets of first model parameter values (71-73), a set of second model parameter values (79) of a parameter evolution model different from the power system asset model, the parameter evolution model describing an evolution of one, several or all first model parameter values (71-73) of the power system asset model, and
generate and provide an output in dependence on at least one of the sets of first model parameter values (71-73) of the power system asset model and the set of second model parameter values (79) of the parameter evolution model.

15. A system, comprising:

a battery energy storage system (11; 11a-c), BESS;
a data acquisition unit (12) operative to collect measurements indicative of a state of the BESS; and
the computing system (13) of claim 14 coupled to the data acquisition unit (12).

10

11

21 P1

12

22 P2

17

13 14 15 16 18

**FIG. 1**

13

31

Interface

32

14

First determination module: asset model

33

Second determination module: parameter evolution

34 Output generation module

IC(s)

Computing system

**FIG. 2**

40

11a    11b    11c

41a    41b    41c

Local control system

Local control system

Local control system

18

HMI

13

FIG. 3

50    51

Receiving measurements

52

Determining sets of first model parameter values

53

Determining a set of second model parameter values for evolution model

54

Generating output

FIG. 4

FIG. 5

$$\begin{bmatrix} p_{1,1} \\ \vdots \\ p_{1,n} \end{bmatrix} \begin{bmatrix} p_{2,1} \\ \vdots \\ p_{2,n} \end{bmatrix} \begin{bmatrix} p_{j,1} \\ \vdots \\ p_{j,n} \end{bmatrix} \begin{bmatrix} p_{j+1,1} \\ \vdots \\ p_{j+1,n} \end{bmatrix} \begin{bmatrix} p_{k,1} \\ \vdots \\ p_{k,n} \end{bmatrix} \begin{bmatrix} p_{k+1,1} \\ \vdots \\ p_{k+1,n} \end{bmatrix}$$

$$\begin{bmatrix} q_1 \\ \vdots \\ q_m \end{bmatrix}$$

FIG. 5

Using set(s) of first parameter values for identifying events on first time scale

Using set of second parameter values for forecast(s) over second time scale

Generating output based on events on first time scale and/or forecast(s) over second time scale

FIG. 6

FIG. 7

FIG. 8

FIG. 9

I

time

FIG. 10

130

Receiving information on operating
and/or ambient conditions ⟋ 131

↓

Optionally: generating and
outputting control signals ⟋ 132

↓

Using set of second parameter values
to determine forecast for the
operating and/or ambient conditions ⟋ 133

↓

Generating output for specified
operating and/or ambient conditions ⟋ 134

FIG. 11

135

136

Computationally generating possible
operating and/or ambient conditions

132

Optionally: generating and
outputting control signals

133

Using set of second parameter values
to determine forecast for the
operating and/or ambient conditions

134

Generating output for specified
operating and/or ambient conditions

FIG. 12

141 — Record measurements indicative of BESS operating state

142 — **Parameter Estimation:** Data Driven Approach to Fit Parameters to Model of BESS

Diagnostics of Sudden Faults / Events

143 — **Parameter Evolution:** Data Driven Approach to Estimate Parameter Evolution Model

Diagnostics of Slower Developing Faults

144 — **Model Evaluation:** Estimate Current and Future States of BESS

145 — **Descriptive Analysis:** Estimate KPIs from Current and Future States of BESS

Prediction of Future Performance and RUL

146 — **Decision:** Determine Previous, Current and Future Performance and RUL

147 — User Interface

140

FIG. 13

FIG. 14

FIG. 15

FIG. 16

Europäisches
Patentamt

European
Patent Office

Office européen
des brevets

# EUROPEAN SEARCH REPORT

Application Number

EP 20 20 6280

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/039787 A1 (BING JAMES M [US]) 24 February 2005 (2005-02-24) * paragraph [0026] * * paragraph [0027] * * paragraph [0028] * * figures 1-7 * ----- | 1-15 | INV. G06Q40/04 |

TECHNICAL FIELDS
SEARCHED (IPC)

G06Q

The present search report has been drawn up for all claims

| Place of search | Date of completion of the search | Examiner |
|---|---|---|
| Munich | 23 February 2021 | Mennerun, Steeve |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

**EP 3 996 027 A1**

## ANNEX TO THE EUROPEAN SEARCH REPORT
## ON EUROPEAN PATENT APPLICATION NO.

EP 20 20 6280

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2021

| Patent document cited in search report | Publication date | Patent family member(s) | Publication date |
|---|---|---|---|
| US 2005039787 A1 | 24-02-2005 | DE 602004010281 T2 | 02-10-2008 |
| | | EP 1660917 A2 | 31-05-2006 |
| | | ES 2297491 T3 | 01-05-2008 |
| | | US 2005039787 A1 | 24-02-2005 |
| | | US 2010017341 A1 | 21-01-2010 |
| | | US 2013013486 A1 | 10-01-2013 |
| | | WO 2005019870 A2 | 03-03-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015160745 A2
- US 20070194756 A1

- EP 2337184 A2

**Non-patent literature cited in the description**

- **X. TANG et al.** Li-ion Battery Parameter Estimation for State of Charge. *American Control Conference,* 2011
- **G. AGGOUN et al.** SOC Estimation Based on OCV and Online Identification Parameters Of Lithium Ion Batteries with ADALINE. *8th International Conference on Modelling, Identification and Control,* 2016

- **D. C. CAMBRON et al.** A lithium-Ion Battery Current Estimation Technique Using an Unknown Input Observer. IEEE, 2017